# EUROPEAN PATENT SPECIFICATION

(11) **EP 1 152 071 B1**
(45) Date of publication and mention of the grant of the patent: **07.09.2005**
(21) Application number: 00303672.0
(22) Date of filing: 02.05.2000
(51) Int. Cl.: C25D 5/34, C25D 7/12, C25D 3/38, H05K 3/22

(54) **Copper plating method**
Kupferplattierungsverfahren
Procédé de placage de cuivre

(43) Date of publication of application: 07.11.2001
(73) Proprietor: Electroplating Engineers of Japan Limited, Tokyo 103-8206 (JP)
(72) Inventor: Sone, Takayuki, Kanagawa-ken 259-0148 (JP); Wachi, Hiroshi, Kohza-gun, Kanagawa-ken 253-0111 (JP)
(74) Representative: Jones, Helen M.M.

(56) References cited:
- EP-A- 1 026 286
- US-A- 2 903 403

## Description

### BACKGROUND OF THE INVENTION

### Field of the Invention

The present invention relates to a method for plating, with copper deposited through electroplating, via holes or grooves of a multilayer printed wiring board, or a wafer having copper microwiring.

### Background Art

Conventionally, via holes or grooves of a multilayer printed wiring board or a wafer having copper microwiring have been buried with copper through electroplating. One purpose of such electroplating is to form a land which enhances mounting density of a printed wiring board. Another purpose is to assure reliability of electric contact in microwiring provided on a wafer.

Typically, such electroplating with copper is carried out in the following manner. Firstly, a non-conductive portion of an object of plating (hereinafter may be referred to as plating object) such as a printed wiring board or a wafer is coated with thin copper film through electroless copper plating or sputtering, to thereby convert the non-conductive portion to a conductive portion which can further be electroplated with copper. Secondly, the thus-prepared object is placed in a Cu-electroplating bath and polarized to a cathode, to thereby complete electrodeposition of copper.

A variety of plating solutions, such as a copper sulfate solution and a copper pyrophosphate solution, have been employed as the aforementioned plating solution. Such plating solutions are generally used in combination with additives such as a variety of polymers, brighteners, and levellers so as to obtain a copper plating layer having uniform physical properties and excellent appearance. In other words, the additives are incorporated into plating solutions so as to regulate deposition of crystal particles and attain a constant deposition rate.

However, when a Cu-electroplating solution containing conventional additives is employed, a brightener as one of the additives is decomposed to be consumed at the anode as electrolysis proceeds. This phenomenon is particularly considerable when an insoluble anode is employed. Therefore, such a plating solution has an unsatisfactory service life, and the composition of the plating solution varies at all times, to thereby affect conditions for depositing a plating layer. Thus, such a plating solution is unfavorable in view of attaining uniform deposition.

The aforementioned unfavorable deposition conditions provide reduced yield in an electroplating operation. For example, when uniform current distribution is not attained in a bottom portion of via holes or grooves, unevenness of current flow attributed to the shape of via holes or grooves results in preferential deposition of copper on a surface portion, to yield uneven deposition. In this case, cavities may be formed in copper burying via holes or grooves and a portion at which deposition of copper is unsatisfactory, to thereby considerably reduce reliability of electric contact in a circuit.

In addition, the aforementioned change in composition of a copper plating solution requires continuous monitoring of the composition so as to perform plating more reliably and more finely. In other words, the composition of the solution must be checked frequently. Checking by a technician is cumbersome, whereas automated checking necessitates facility costs, to thereby increase product cost. Furthermore, in recent years, there has been demand for finer plating to catch up with techniques applied to produce a finer printed wiring board and wafer.

### SUMMARY OF THE INVENTION

In view of the foregoing, the present inventors have conducted earnest studies and have accomplished the present invention, which is directed to a method for burying via holes and grooves through electroplating with copper, the method prolonging the service life of a plating solution and suppressing compositional changes of the plating solution.

The present inventors have considered that a plating object *per se* may be subjected to certain treatment instead of incorporating an additive into a copper plating solution, if a brightener one of the additives incorporated into a copper plating solution is always decomposed through oxidation at an anode and an effective alternative which is not decomposed at an anode interface cannot be found.

On the basis of the aforementioned concept, an additive which has conventionally been incorporated into a copper electroplating solution is adsorbed in advance on an object of plating such as a printed wiring board or a wafer and, then, the object is electroplated with copper. The present inventors have conducted electroplating in such a manner, and have discovered that copper is electrodeposited reliably in a favorable state and the service life of a plating solution is prolonged, as compared with a conventional electroplating method.

Accordingly, the present invention provides a method for filling, with copper deposited through electroplating, depressed portions of a substrate, which is of a multilayer printed wiring board or of a wafer having copper microwiring, which method comprises
adsorbing onto the substrate an aqueous solution containing a brightener component comprising one or more species selected from the group consisting of bis(3-sulfopropyl) disulfide and a disodium salt thereof; bis(2-sulfopropyl) disulfide and a disodium salt thereof; bis(3-sulfo-2-hydroxypropyl) disulfide and the disodium salt thereof; bis(4-sulfopropyl) disulfide and the disodium salt thereof; bis(p-sulfophenyl) disulfide and the disodium salt thereof; 3-(benzothiazolyl-2-thio) propylsulfonic acid and the sodium salt thereof; an N,N-dimethyldithiocarbamic acid-(3-sulfopropyl)-ester and the sodium salt thereof; an O-ethyl-diethyl carbonate-S-(3-sulfopropyl)-ester and the potassium salt thereof; and thiourea and derivatives thereof; the brightener being present in the solution in a total amount of 0.001-10 g/l; and
electroplating the treated substrate in a copper plating solution containing no brightener component.

Preferably the brightener solution further contains:-
a leveller component which comprises one or more species selected from the group consisting of acetamide, propylamide, benzamide, acrylamide, methacrylamide, N,N-dimethylacrylamide, N,N-diethylmethacrylamide, N,N-diethylacrylamide, N,N-dimethylmethacrylamide, N-(hydroxymethyl)acrylamide, polyacrylic amide, a polyacrylic amide hydrolyzate, THIOFLAVINE, and SAFRANIN such that the total amount of the leveller component is controlled to 0.001-10 g/l and
a polymer component which comprises one or more species selected from the group consisting of polyvinyl alcohol, carboxymethyl cellulose, polyethylene glycol, polypropylene glycol, a stearic acid polyethylene glycol ester, a stearyl alcohol polyethylene glycol ether, a nonyl phenol polyethylene glycol ether, an octyl phenol polyethylene glycol ether, poly(ethylene-propylene) glycol, and a β-naphthol polyethylene glycol etherh in a total amount of 0.001-10 g/l.

Preferably, electroplating is carried out at a copper plating solution temperature of 10-60°C and a current density of 0.1-10 A/dm².

Various other objects, features and many of the attendant advantages of the present invention will be readily appreciated through reading of the following detailed description of the preferred embodiments.

### DETAILED DESCRIPTION OF THE PREFERRED EMBODIMENTS

The method for filling, with copper deposited through electroplating, depressed portions such as through holes, indentations or grooves of a multilayer printed wiring board or a wafer having copper microwaving according to the present invention comprises adsorbing the aqueous solution containing an additive, particularly a brightener component, onto an object of plating and carrying out electroplating in a copper plating solution containing no brightener component. No particular limitation is imposed on the type of copper electroplating solution, and solutions which have conventionally been employed may be used.

To a brightener component, a leveller component and polymer component may be added so as to enhance the performance of the brightener component.

When the concentration of the brightener component is 0.001 g/l or less, uniform adsorption of the brightener is not attained, whereas when the concentration is 10 g/l or more, a considerable effect commensurate with addition is not attained.

The aforementioned polymer component is incorporated into an aqueous solution preferably in a total concentration of 0.001-10 g/l, which allows copper to deposit in the most uniform state.

When a leveller component is added to the brightener component which is adsorbed onto an object of plating, the leveller is incorporated preferably in a total concentration of 0.001-10 g/l into an aqueous solution containing a brighter component, which concentration allows copper to deposit in the most uniform state.

No particular limitation is imposed on the method for adsorbing a brightener, and any method suitable for a production line, such as dipping, showering, or spraying, may be employed. The concentration of a brightener in an aqueous solution is not particularly limited, and the concentration is controlled such that unimolecular film of a target brightener is formed on a plating object, as can be determined in consideration of handling speed of a production line, cost, etc. The treatment for adsorbing a brightener onto an object of plating in advance is hereinafter referred to as "brightener adsorption".

In order to attain excellent properties and appearance of copper plating, electroplating is carried out preferably at a copper plating solution temperature of 10-60°C and a current density of 0.1-10 A/dm².

### EXAMPLES

Best modes for carrying out the present invention will next be described by way of example.

A wafer having Cu-microwaving was electroplated with copper, to thereby investigate performance for filling, hereinafter referred to as "burying", grooves contained in the wiring portion. The grooves comprised cylindrical depressed portions having a diameter of 0.20 µm and a depth of 1.0 µm. A cross-section of the depressed portion was macroscopically observed at a magnification of ^{x}2 - ^{x}10 through a magnifying lens, to thereby check covering performance. Adhesion of Cu plating was evaluated by observing a plating interface under an optical metallurgical microscope at an appropriate magnification and by observing the same under a scanning electron microscope at a magnification of ^{x}10,000-^{x}50,000.

The results are shown in Table 1. Sample Nos. 4 and 5 in Table 1 were not subjected to brightener adsorption, whereas Sample Nos. 1 to 3 were subjected to brightener adsorption prior to electrolysis. Brightener adsorption was carried out by dipping, in a 0.005 g/l solution of bis(2-sulfopropyl) disulfide for 10 seconds, a wafer which had been washed with pure water.

Subsequently, electroplating was carried out in a plating solution containing copper sulfate. The composition of the plating solution and plating conditions are as follows.

### A. Composition of plating solution

| | | |
|---|---|---|
| Composition of copper sulfate plating solution | copper | 28 g/l |
| | sulfate | 200 g/l |
| | chloride | 50 mg/l |
| Microfab Cu 2100 | amounts shown in Table 1 | |

### B. Plating conditions

| | |
|---|---|
| Solution temperature | 20°C |
| Current density | 1.0 A/dm² |
| Electrolysis duration | 4.5 min |
| Anode | Cu-P (soluble) or Pt/Ti (insoluble) |

**Table 1**

| Sample | Plating conditions | | Quality evaluation of Cu plating | | |
|---|---|---|---|---|---|
| | brightener adsorption | Additive in Cu plating solution | Appearance (to the naked eye) | burying performance | adhesion |
| 1 | yes | 0 ml/l | glossy | good | good |
| 2 | | 10 ml/l¹⁾ | | | |
| 3 | | 10 ml/l²⁾ | | | |
| 4 | no | 10 ml/l³⁾ | glossy | good | good |
| 5 | | 0 ml/l | non glossy | poor | poor |

| | | | | | |
|---|---|---|---|---|---|
| 1) 2 g/l of polyethylene glycol (polymer component) | | | | | |
| 2) 2 g/l of polyethylene glycol (polymer component) and 0.05 g/l of acrylamide (leveller component) | | | | | |
| 3) Microfab Cu 2100 and a polymer component, a leveller component, and a brightener component | | | | | |

Sample No. 4 in Table 1 refers to a Cu-plated fine product obtained through a conventional electroplating method, and serves as a reference sample to Sample Nos. 1 to 3, which fall within the scope of the present invention. Sample No. 5 was not subjected to brightener adsorption and was subjected to electroplating in a plating solution containing no conventional additive. Sample No. 5 is regarded as a sample which is unsatisfactorily electroplated for burying wiring. Sample Nos. 1 to 5 in Table 1 were electroplated by use of a soluble anode; i.e., P-containing Cu, whereas Sample Nos. 1' and 4' in Table 2 were electroplated by use of an insoluble anode; i.e., Pt/Ti.

The results show that Sample Nos. 1 to 3 which fall within the scope of the present invention were electroplated with copper to attain excellent burying performance and plating adhesion. These samples are similar in quality to Sample No. 4. The results indicate that brightener adsorption which is carried out prior to plating achieves favorable electroplating for burying wiring, regardless of additives incorporated into an electroplating solution. As indicated above, appearance of copper plating of Sample No. 5 was poor, and burying performance was unsatisfactory.

In order to assess the service life of each copper plating solution, plating solutions used for preparing Sample Nos. 1 to 3 were compared with that used for preparing Sample No. 4 in terms of plating performance. When a copper plating solution contained an additive, no replenishment was carried out, and a test was run in the manner of continuous electrolysis. The results are shown in Table 2. Conditions including electrolysis conditions for preparing Sample Nos. 1 and 4 and those for preparing Sample Nos. 1' and 4' were identical, except that different anode materials were employed.

**Table 2**

| Sample | Quality of plating | Electricity (A^{.}hr/l) | | | | |
|---|---|---|---|---|---|---|
| | | 0.00 | 0.25 | 0.50 | 1.00 | 2.00 |
| 1 | appearance of plating | glossy | | | | |
| | burying performance | good | | | | |
| 1' | appearance of plating | glossy | | | | |
| | burying performance | good | | | | |
| 2 | appearance of plating | glossy | | | | |
| | burying performance | good | | | | |
| 3 | appearance of plating | glossy | | | | |
| | burying performance | good | | | | |
| 4 | appearance of plating | glossy | | | non-glossy | |
| | burying performance | good | | poor | | |
| 4' | appearance of plating | glossy | non-glossy | | | |
| | burying performance | good | poor | | | |

As is clear from Table 2, when a plating solution for preparing Sample No. 4 was employed without replenishment, appearance and coverage performance of plating deteriorated with elapse of the time of current flow. In contrast, plating solutions for preparing Sample Nos. 1 to 3 according to the present invention exhibited no deterioration with elapse of the time of current flow, to thereby maintain plating performance. Thus, in the present invention, the service performance of a copper electroplating solution is maintained for a long period of time and a plating solution having considerably high stability is obtained.

Furthermore, Sample Nos. 1' and 4', which had been prepared by use of an insoluble Pt/Ti anode, were compared with each other. The plating solution for preparing Sample No. 1' exhibited constant plating performance, whereas the plating solution for preparing Sample No. 4' was considerably deteriorated. Thus, the present invention realizes use of an insoluble anode. The present invention also eliminates decomposition of an additive for a plating solution at an anode and a cumbersome step for maintaining an anode when a soluble anode is employed.

As described hereinabove, the present invention prolongs the service life of a copper electroplating solution; reduces operating costs for electroplating; and omits cumbersome control of a plating solution. Therefore, the invention can reduce total production cost of a copper-plated product and facilitate use of an insoluble anode. As compared with a conventional method for electroplating with copper, the deposited copper layer which is obtained according to the present invention attains uniform deposition, and can be applied to a finer electric circuit. Thus, occurrence of defective products is effectively reduced.

## Claims

1. A method for filling, with copper deposited through electroplating, depressed portions of a substrate, which is of a multilayer printed wiring board or of a wafer having copper microwiring, which method comprises
adsorbing onto the substrate an aqueous solution containing a brightener component comprising one or more species selected from the group consisting of bis(3-sulfopropyl) disulfide and a disodium salt thereof; bis(2-sulfopropyl) disulfide and a disodium salt thereof; bis(3-sulfo-2-hydroxypropyl) disulfide and the disodium salt thereof; bis(4-sulfopropyl) disulfide and the disodium salt thereof; bis(p-sulfophenyl) disulfide and the disodium salt thereof; 3-(benzothiazolyl-2-thio) propylsulfonic acid and the sodium salt thereof; an N,N-dimethyldithiocarbamic acid-(3-sulfopropyl)-ester and the sodium salt thereof; an O-ethyl-diethyl carbonate-S-(3-sulfopropyl)-ester and the potassium salt thereof; and thiourea and derivatives thereof; the brightener being present in the solution in a total amount of 0.001-10 g/l; and
electroplating the treated substrate in a copper plating solution containing no brightener component.

2. A method according to claim 1 in which the said aqueous solution further comprises:
(A) : a leveller component which comprises one or more species selected from the group consisting of acetamide, propylamide, benzamide, acrylamide, methacrylamide, N,N-dimethylacrylamide, N,N-diethylmethacrylamide, N,N-diethylacrylamide, N,N-dimethylmethacrylamide, -(hydroxymethyl)acrylamide, polyacrylic amide, a polyacrylic amide hydrolyzate, THIOFLAVINE, and SAFRANIN, in a concentration in the range 0.001 - 10 g/l; and
(B): a polymer component which comprises one or more species selected from the group consisting of polyvinyl alcohol, carboxymethyl cellulose, polyethylene glycol, polypropylene glycol, stearic acid polyethylene glycol ester, stearyl alcohol polyethylene glycol ether, a nonyl phenol polyethylene glycol ether, octyl phenol polyethylene glycol ether, poly(ethylene-propylene) glycol, and β-naphthol polyethylene glycol ether; in a concentration in the range 0.001-10 g/l.

3. A method according to claim 1 or 2, wherein electroplating is carried out at a copper plating solution temperature of 10-60°C and a current density of 0.1-10 A/dm².

4. A method according to claim 1 or claim 2 in which the electroplating utilises an insoluble anode.

5. A method according to claim 4 in which the anode is formed of Pt/Ti.

## Patentansprüche

1. Verfahren zum Füllen von vertieften Abschnitten eines Substrats mit durch Elektroplattierung abgeschiedenem Kupfer, das Substrat besteht aus einer Vielschicht-Verdrahtungsleiterplatte oder aus einer Halbleiterscheibe mit Kupfermikroverdrahtung, wobei das Verfahren umfaßt
auf dem Substrat Adsorbieren einer wässrigen Lösung, welche eine Glanzmittelkomponente enthält, die eine oder mehrere Spezies umfaßt, die aus der Gruppe ausgewählt wurden, die aus Bis(3-sulfopropyl)disulfid und einem Dinatriumsalz davon; Bis(2-sulfopropyl)disulfid und einem Dinatriumsalz davon; Bis(3-sulfo-2-hydroxypropyl)disulfid und dem Dinatriumsalz davon; Bis(4-sulfopropyl)disulfid und dem Dinatriumsalz davon; Bis(p-sulfophenyl)disulfid und dem Dinatriumsalz davon; 3-(Benzothiazolyl-2-thio)propylsulfonsäure und dem Natriumsalz davon; einem N,N-Dimethyldithiocarbamidsäure-(3-sulfopropyl)-ester und dem Natriumsalz davon; einem o-Ethyl-diethylcarbonat-S-(3-sulfopropyl)-ester und dem Kaliumsalz davon; und Thioharnstoff und Derivaten davon besteht; das Glanzmittel ist in der Lösung in einer Gesamtmenge von 0,001 - 10 g/l enthalten; und
Elektroplattieren des behandelten Substrats in einer Kupferplattierungslösung, welche keine Glanzmittelkomponente enthält.

2. Verfahren nach Anspruch 1, in welchem die wässrige Lösung ferner umfaßt:
(A): eine Nivellierkomponente, welche eine oder mehrere Spezies umfaßt, die aus der Gruppe ausgewählt wurden, welche aus Acetamid, Propylamid, Benzamid, Acrylamid, Methacrylamid, N,N-Dimethylacrylamid, N,N-Diethylmethacrylamid, N,N-Diethylacrylamid, N,N-Dimethylmethacrylamid, N-(Hydroxymethyl)acrylamid, Polyacrylamid, einem Polyacrylamidhydrolysat, THIOFLAVIN und SAFRANIN in einer Konzentration in dem Bereich von 0,001 - 10 g/l besteht; und
(B): eine Polymerkomponente, welche eine oder mehrere Spezies umfaßt, die aus der Gruppe ausgewählt wurden, welche aus Polyvinylalkohol, Carboxymethylzellulose, Polyethylenglycol, Polypropylenglycol, Stearinsäurepolyethylenglycolester, Stearylalkoholpolyethylenglycolether, einem Nonylphenolpolyethylenglycolether, Octylphenolpolyethylenglycolether, Poly(ethylenpropylen)glycol und β-Naphtholpolyethylenglycolether in einer Konzentration in dem Bereich von 0,001 - 10 g/l besteht.

3. Verfahren nach Anspruch 1 oder 2, wobei die Elektroplattierung bei einer Temperatur der Kupferplattierungslösung von 10 - 60 °C und einer Stromdichte von 0,1 - 10 A/dm² ausgeführt wird.

4. Verfahren nach Anspruch 1 oder 2, in welchem die Elektroplattierung eine unlösliche Anode verwendet.

5. Verfahren nach Anspruch 4, in welchem die Anode aus Pt/Ti gebildet ist.

## Revendications

1. Procédé pour remplir par du cuivre déposé par placage électrolytique des parties creuses d'un support d'une carte à circuit imprimé en plusieurs couches ou d'une galette qui comprend un micro-câblage en cuivre, lequel procédé comprend les étapes qui consistent à :
adsorber sur le support une solution aqueuse qui comprend un composant de brillant qui comprend une ou plusieurs substances sélectionnées dans l'ensemble constitué du bisulfure de bis(3-sulfopropyle) et de son sel disodique, du bisulfure de bis(2-sulfopropyle) et de son sel disodique, du bisulfure de bis(3-sulfo-2-hydroxypropyle) et de son sel disodique, du bisulfure de bis(4-sulfopropyle) et de son sel disodique, du bisulfure de bis(p-sulfophényle) et de son sel disodique, de l'acide 3-(benzothiazolyl-2-thio)propylsulfonique et de son sel sodique, du (3-sulfopropyl)ester de l'acide diméthyldithiocarbamique et de son sel sodique, du S-(3-sulfopropyl)ester du carbonate de O-éthyldiéthyle et son sel potassique et de la thiourée et de ses dérivés, le composant de brillant étant présent dans la solution en quantité totale de 0,001 à 10 g/l, et
plaquer électrolytiquement le support traité dans une solution de placage de cuivre qui est dépourvue de composant de brillant.

2. Procédé selon la revendication 1, dans lequel ladite solution aqueuse comprend en outre :
(A) : un composant aplanisseur qui comprend une ou plusieurs substances sélectionnées dans l'ensemble constitué de l'acétamide, du propylamide, du benzamide, de l'acrylamide, du méthacrylamide, du N,N-diméthylacrylamide, du N,N-diéthylméthacrylamide, du N,N-diéthylacrylamide, du N,N-diméthylméthacrylamide, du N,N-diméthyl(hydroxyméthyl)acrylamide, du polyacrylamide, d'un hydrolysat de polyacrylamide, de THIOFLAVINE et de SAFRANIN, en concentration comprise dans la plage de 0,001 à 10 g/l, et
(B) : un composant polymère qui comprend une ou plusieurs substances sélectionnées dans l'ensemble constitué de l'alcool polyvinylique, de la carboxyméthylcellulose, du polyéthylène glycol, du polypropylène glycol, du poly(éthylène glycolester de l'acide stéarique), du poly(éthylène glycoléther de l'alcool stéarylique), du polyéthylène glycoléther de nonylphénol, du polyéthylène glycoléther d'octylphénol, du poly(éthylène-propylène)glycol et du poly éthylène glycoléther de β-naphtol), en concentration comprise dans la plage de 0,001 à 10 g/l.

3. Procédé selon les revendications 1 ou 2, dans lequel le placage électrolytique est réalisé à une température de la solution de placage de cuivre comprise entre 10 et 60°C et à une densité de courant comprise entre 0,1 et 10 A/dm².

4. Procédé selon les revendications 1 ou 2, dans lequel le placage électrolytique utilise une anode insoluble.

5. Procédé selon la revendication 4, dans lequel l'anode est formée de Pt/Ti.
